# EUROPÄISCHE PATENTSCHRIFT

(11) **EP 4 491 886 B1**
(45) Veröffentlichungstag und Bekanntmachung des Hinweises auf die Patenterteilung: **19.11.2025**
(21) Anmeldenummer: 23185285.6
(22) Anmeldetag: 13.07.2023
(51) Int. Cl.: F16B 5/06, F16B 21/08, F25D 29/00

(54) **VORRICHTUNG ZUR MECHANISCHEN BEFESTIGUNG EINES MODULS AN EINER WAND EINES GERÄTES MIT EINER DAS MODUL AUFNEHMENDEN MONTAGEÖFFNUNG**
DEVICE FOR MECHANICALLY FASTENING A MODULE TO A WALL OF AN APPLIANCE WITH AN OPENING FOR MOUNTING THE MODULE
DISPOSITIF DE FIXATION MÉCANIQUE D'UN MODULE SUR UNE PAROI D'UN APPAREIL AVEC UNE OUVERTURE DE MONTAGE

(43) Veröffentlichungstag der Anmeldung: 15.01.2025
(73) Patentinhaber: Eppendorf SE, 22339 Hamburg (DE)
(72) Erfinder: Laganovskis, Peteris, 22339 Hamburg (LV); Mensch, Sören, 22339 Hamburg (DE); Knutzen, Tim, 22339 Hamburg (DE); Ebbecke, Andreas, 22339 Hamburg (DE)
(74) Vertreter: Hauck Patent- und Rechtsanwälte PartmbB

(56) Entgegenhaltungen:
- WO-A1-2010/029042
- CN-A- 108 800 734
- DE-A1- 102019 203 114

## Beschreibung

Die Erfindung betrifft eine Vorrichtung zur mechanischen Befestigung eines Moduls an einer Wand eines Gerätes mit einer das Modul aufnehmenden Montageöffnung.

Laborgeräte wie Shaker, Inkubatoren, Cycler, Thermomischer, Zentrifugen, Automaten und Geräte für andere Anwendungsbereiche weisen vielfach ein User Interface (UI)-Modul auf, das in eine Montageöffnung einer Wand des Gerätes eingesetzt und an der Wand befestigt ist. Das UI-Modul ist beispielsweise eine Folientastatur, ein Touchscreen, eine Kombination aus PCBA (*printed circuit board assembly*) und Eingabeelementen wie Drehknöpfe oder Folientasten.

Bekannt ist, das UI-Modul in eingesetzter Stellung in der Montageöffnung durch Schrauben und/oder Verkleben zu fixieren. Ferner ist bekannt, das Modul direkt in einer Montageöffnung des Gerätes zu verklipsen.

Die Konstruktion des Moduls und der Wand mit der Montageöffnung des Gerätes wird individuell im Rahmen der jeweiligen Geräteentwicklung durchgeführt und individualisiert. Diese Individualisierung führt bei jeder Konstruktion zu einem entsprechend hohen Aufwand für Gestaltung, Prüfung und Optimierung.

Die bekannten Verschraubungen des Moduls sind lösbare Verbindungen, die in vielen Fällen unterschiedlich ausgeführt sind. Infolgedessen ist eine hohe Anzahl vorzuhaltender Werkzeuge bei Produktion und Service erforderlich. Verschraubungen haben zudem den Nachteil, dass Bauraum verlorengeht, um den Zugang der Verschraubungen für Schraubwerkzeuge zu gewährleisten.

Eine Verklebung des Moduls mit dem Gehäuse hat den Nachteil, dass das finale Klebeergebnis erst einige Zeit (bis zu mehrere Stunden) nach der Verklebung zur Verfügung steht, was hinderlich bei Montage und Service sein kann. Zudem erfordert eine verlässliche Verklebung spezielles Fertigungs-Know-how. Eine Demontage ist beim Kleben nicht zerstörungsfrei möglich. Gegebenenfalls müssen im Schadensfall ganze Geräteteile mit dem UI-Modul ausgetauscht werden, um einen Fehler zu beheben.

Eine Schnappverbindung des Moduls direkt mit dem Gerät erfordert eine genaue Abstimmung des Moduls und der Montageöffnung einschließlich der Toleranzen und Werkzeuge, was zu einem hohen Aufwand in der Entwicklung führt. Jedes Spritzgusswerkzeug für das Geräteteil mit der Montageöffnung bedarf zur Integration des UI-Moduls einer aufwändigen Abstimmung mit dem Werkzeug oder dem Design für das UI-Modul. Dieser Nachteil kommt insbesondere bei mittleren und kleinen Stückzahlen zum Tragen.

Die CN 108800734 A beschreibt ein Touchpanel-Display, das an einer Halterung mit Schnapphaken befestigt ist. Die Halterung ist in eine Öffnung einer Gehäuseabdeckung eingesetzt und die Schnapphaken sind mit Schnappaufnahmen der Gehäuseabdeckung verschnappt. Die Verschnappung zwischen Halterung und Gehäuseabdeckung erfordert eine präzise Abstimmung der Bauteile aufeinander.

Davon ausgehend liegt der Erfindung die Aufgabe zugrunde, eine Vorrichtung zur mechanischen Befestigung eines Moduls an einer Wand eines Gerätes mit einer das Modul aufnehmenden Montageöffnung zur Verfügung zu stellen, bei der der Aufwand für die Abstimmung der Bauteile aufeinander und der für die Fertigung erforderlichen Werkzeuge verringert ist.

Die Aufgabe wird erfindungsgemäß durch eine Vorrichtung gemäß Anspruch 1 gelöst. Vorteilhafte Ausführungsarten der erfindungsgemäßen Vorrichtung sind in Unteransprüchen und in der Beschreibung angegeben.

Die erfindungsgemäße Vorrichtung zur mechanischen Befestigung eines Moduls an einer Wand eines Gerätes mit einer das Modul aufnehmenden Montageöffnung umfasst:
- einen Modulträger, der einen plattenförmigen Grundkörper zum Einsetzen in die Montageöffnung und mindestens ein erstes Schnappelement am Außenumfang des Grundkörpers aufweist,
- ein Modul, das auf der Vorderseite des Grundkörpers angeordnet und am Modulträger befestigt ist,
- eine Stützplatte zum Abstützen auf einer vorderen Seite der Wand mit der Montageöffnung, die mit dem Modulträger oder Modul verbunden ist und parallel zur Hauptebene des Grundkörpers nach außen vorsteht,
- einen Rastrahmen, der eine Rahmenöffnung zum Einsetzen eines hinteren Teils des Grundkörpers und mindestens ein zweites Schnappelement am Innenumfang aufweist,
- mindestens ein Federelement, das ausgebildet und angeordnet ist, den Rastrahmen federnd auf der hinteren Seite der Wand neben der Montageöffnung abzustützen und/oder die Stützplatte federnd auf der vorderen Seite der Wand abzustützen,
- wobei das erste Schnappelement und das zweite Schnappelement ausgebildet sind, miteinander zu verschnappen, wenn der Grundkörper in die Rahmenöffnung eingesetzt ist, wobei zwischen der Rückseite der Stützplatte und der Vorderseite des Rastrahmens ein Abstand zur Aufnahme eines die Montageöffnungen umgebenden Randbereichs der Wand vorhanden ist.

Bei der erfindungsgemäßen Vorrichtung ist der Modulträger mit seinem plattenförmigen Grundkörper in die Montageöffnung des Gerätes einsetzbar. Das Modul ist auf der Vorderseite des Grundkörpers angeordnet und am Modulträger befestigt. Das Modul oder der Modulträger weist eine Stützplatte auf, mit der sich der Modulträger oder das Modul an der vorderen Seite der Wand mit der Montageöffnung des Gerätes abstützen kann. Der Rastrahmen weist eine Rahmenöffnung auf, in die der hintere Teil des Grundkörpers einsetzbar ist. Die Vorrichtung umfasst mindestens ein Federelement, das ausgebildet und angeordnet ist, den Rastrahmen federnd auf der hinteren Seite der Wand neben der Montageöffnung abzustützen und/oder die Stützplatte federnd auf der vorderen Seite der Wand abzustützen. Der Modulträger hat am Außenumfang des Grundkörpers mindestens ein erstes Schnappelement und der Rastrahmen hat am Innenumfang mindestens ein zweites Schnappelement. Das erste Schnappelement und das zweite Schnappelement sind ausgebildet, sodass sie miteinander verschnappbar sind, wenn der Grundkörper in die Rahmenöffnung eingesetzt ist. Wenn das erste Schnappelement und das zweite Schnappelement miteinander verschnappt sind, ist zwischen der Rückseite der Stützplatte und der Vorderseite des Rastrahmens ein Abstand zur Aufnahme eines die Montageöffnung umgebenden Randbereichs der Wand vorhanden. Dies ermöglicht es, zunächst den Modulträger in die Montageöffnung und danach mit dem hinteren Teil des Rastrahmens in die Rahmenöffnung einzusetzen bzw. den Rastahmen mit der Rahmenöffnung auf den hinteren Teil des Grundkörpers aufzuschieben. Wenn das erste Schnappelement und das zweite Schnappelement miteinander verschnappt sind, ist der die Montageöffnung umgebende Randbereich der Wand zwischen der Rückseite der Stützplatte und der Vorderseite des Rastrahmens angeordnet. Infolgedessen stützt sich die Stützplatte an der vorderen Seite der Wand und der Rastrahmen über das Federelement an der hinteren Seite der Wand ab und/oder stützt sich die Stützplatte über das Federelement an der vorderen Seite der Wand und der Rastrahmen an der hinteren Seite der Wand ab.

Die Vorrichtung ist durch Eingriff des Modulträgers in die Montageöffnung und Festklemmen der Stützplatte und des Rastrahmens über das Federelement auf der vorderen und hinteren Seite der Wand am Gerät fixiert. Durch unterschiedliche elastische Verformung des Federelementes können Toleranzen zwischen den Bauteilen Modulträger, Stützplatte, Rastrahmen und Wand ausgeglichen werden. Auf eine präzise Abstimmung von Modulträger und Montageöffnung kommt es nicht an, da der Modulträger nur mit dem Grundkörper in die Montageöffnung einsetzbar sein muss und die Stützplatte die Spalte zwischen Grundkörper und Montageöffnung abdeckt. Die Wandstärke der Wand und die Montageöffnung im Gehäuse können grob toleriert werden. Die Toleranzen der Wandstärke werden durch die elastische Verformung der Federelemente ausgeglichen und die Spalte, die aufgrund der Toleranzen der Wandöffnung zwischen dieser und dem darin eingreifenden Grundkörper verbleiben, werden durch die Stützplatte abgedeckt. Die Genauigkeiten sind in den Modulträger und den Rastrahmen der Vorrichtung gelegt. Die Schnappverbindung zwischen Modulträger und Rastrahmen kann lösbar ausgeführt sein, sodass eine Demontage möglich ist. Die Schnappverbindung kann so ausgebildet sein, dass die Bauteile ohne spezielles Werkzeug an der Wand montierbar und/oder demontierbar sind.

Die Vorrichtung kann so ausgebildet sein, dass Modulträger und Rastrahmen oder eines der beiden vorstehenden Bauteile für verschiedene Geräte verwendbar sind. Hierdurch können verstärkt Gleichteile für verschiedene Geräte verwendet werden. Falls eine der beiden Komponenten spezifisch an verschiedene Geräte angepasst werden muss, sind gegebenenfalls nur geringe Änderungen erforderlich. Dies ist beispielsweise der Fall, wenn der Modulträger spezifisch an das vorgesehene Modul oder das Gerät angepasst werden muss. Zudem kann durch die Schnappverbindung eine einfachere und schnellere Montage und Service erreicht werden. Da der Toleranzausgleich über die Abstützung des Federelements an der Wand des Gerätes erfolgt, werden die Kräfte zwischen dem ersten Schnappelement und dem zweiten Schnappelement durch den Toleranzausgleich nicht oder nur unwesentlich beeinflusst.

Der Konstruktionsaufwand für neu zu entwickelnde Geräte kann durch den möglichen Einsatz von Gleichteilen verringert werden.

Wenn die Stützplatte mit dem Modulträger verbunden ist, werden die Klemmkräfte über den Modulträger abgeleitet und vom Modul ferngehalten. Dies kann insbesondere bei empfindlichen Modulen von Vorteil sein, beispielsweise bei Displays mit einem Deckglas. Wenn die Stützplatte mit dem Modul verbunden ist, kann hierdurch das Design verbessert werden, weil das Modul eng an der Gehäusewand anliegt und nicht vom Rand einer Stützplatte des Modulträgers umgeben ist. Gemäß einer weiteren Ausführungsart ist die Stützplatte einstückig mit dem Modulträger oder einstückig mit dem Modul verbunden. Hierdurch kann die Herstellung und Montage vereinfacht werden. Bei einstückiger Ausbildung mit dem Modulträger kann die Stützplatte in Form eines Rahmens ausgebildet sein, der am Innenumfang mit einem nach hinten vorstehenden Grundkörper verbunden ist. Der Rahmen kann eine Aussparung umgrenzen, die das Modul aufnimmt. Bei einstückiger Ausführung mit dem Modul kann die Stützplatte als seitlich vorstehender Randbereich eines Deckglases eines Touchpanels oder anderen Moduls ausgebildet sein.

Gemäß einer weiteren Ausführungsart, ist der Modulträger und der Rastrahmen rechteckig oder kreisrund. Vielfach sind Module für den Einsatz in Geräten rechteckig oder kreisrund ausgebildet und die rechteckige oder kreisrunde Ausbildung der Vorrichtung ermöglicht eine gute Anpassung und platzsparende Befestigung der Vorrichtung am Gerät.

Gemäß einer weiteren Ausführungsart weist der Modulträger auf der Vorderseite eine Aussparung auf und ist das Modul in die Aussparung eingesetzt. Durch die Aussparung wird eine geschützte und platzsparende Unterbringung des Moduls am Modulträger ermöglicht. Gemäß einer weiteren Ausführungsart ist die Aussparung eine Fensteröffnung in der Stützplatte und/oder eine Vertiefung im Grundkörper des Modulträgers.

Gemäß einer weiteren Ausführungsart ist das Modul über eine Klebeverbindung mit dem Modulträger verbunden. Hierdurch kann eine spannungsfreie Befestigung des Moduls am Modulträger erreicht werden. Es sind auch andere Befestigungen des Moduls am Modulträger möglich, beispielsweise durch Festklemmen des Moduls am Modulträger, durch Festschrauben oder Sichern des Moduls mit Sicherungsringen oder anderen Sicherungsmitteln am Modulträger. Auch können verschiedene Befestigungsarten kombiniert werden.

Gemäß einer weiteren Ausführungsart weist der Grundkörper eine verrippte Platte auf. Hierdurch kann ein stabiler Grundkörper mit geringem Materialeinsatz erreicht werden. Ein stabiler Grundkörper kann eine Beschädigung eines Moduls durch auf den Modulträger wirkende Kräfte vermeiden.

Gemäß einer weiteren Ausführungsart ist das Modul ein Display, ein Monitor, eine Tastatur, ein Touchscreen, ein anderes UI-Modul oder eine transparente Scheibe. Das Modul kann insbesondere als Touchpanel ausgebildet sein. Die transparente Scheibe kann insbesondere ein Sichtfenster sein, beispielsweise eine Scheibe an einer Zentrifuge.

Gemäß einer weiteren Ausführungsart ist auf der Rückseite des Grundkörpers eine Elektronikplatine angeordnet. Bei der Elektronikplatine kann es sich um eine elektronische Steuerung und/oder eine Energieversorgung eines am Modulträger befestigten elektronischen Moduls handeln.

Gemäß einer weiteren Ausführungsart stehen von der Rückseite des Grundkörpers nach hinten Schraubdome vor und ist die Elektronikplatine an Schraublöchern mittels Schrauben auf den Schraubdomen befestigt. Hierdurch wird eine sichere sowie montage- und servicefreundliche Befestigung der Elektronikplatine erreicht. Gemäß einer weiteren Ausführungsart stehen von der Rückseite des Grundkörpers nach hinten Positionsnasen vor und ist die Elektronikplatine an Positionierungslöchern auf den Positionsnasen geführt. Hierdurch wird eine exakte Ausrichtung der Elektronikplatine auf den Modulträger erreicht.

Gemäß einer weiteren Ausführungsart weist der Modulträger am Außenumfang mindestens einen nach hinten vorstehenden Schnapphaken und der Rastrahmen am Innenumfang mindestens eine Schnappaufnahme für den Schnapphaken auf und/oder weist der Rastrahmen am Innenumfang mindestens einen nach vorn vorstehenden Schnapphaken und der Modulträger am Außenumfang mindestens eine Schnappaufnahme für den Schnapphaken auf. Die Schnapphaken können ausschließlich am Modulträger und die Schnappaufnahmen ausschließlich am Rastrahmen ausgebildet sein oder umgekehrt. Auch ist es möglich, dass beide Bauteile sowohl Schnapphaken als auch Schnappaufnahmen aufweisen, wobei die Anordnung der Schnapphaken und Schnappaufnahmen aufeinander abgestimmt sind, sodass immer ein Schnapphaken des einen Bauteils mit einer Schnappaufnahme des anderen Bauteils verschnappbar ist.

Gemäß einer weiteren Ausführungsart weist der Rastrahmen die Schnapphaken und weist der Modulträger die Schnappaufnahmen auf. Grundsätzlich sind die vorstehenden Schnapphaken empfindlichere Schnappelemente als die Schnappaufnahmen, da die Schnapphaken vor dem Verschnappen seitlich ausgelenkt werden. Die Anordnung der Rasthaken am Rastrahmen hat den Vorteil, dass die empfindlicheren Schnappelemente an dem Bauteil angeordnet sind, das besonders gut als Gleichteil für den Einsatz an verschiedenen Geräten und für eine kostengünstige Produktion mit hoher Stückzahl geeignet ist.

Gemäß einer weiteren Ausführungsart hat der Schnapphaken einen ein- oder zweiarmigen Hebel mit einem ersten Hebelarm mit einem Haken zum Einschnappen in eine Schnappaufnahme und einen zweiten Hebelarm zum Lösen der Schnappverbindung mit der Schnappaufnahme. Dies ist vorteilhaft für den Service, weil eine Demontage ohne Einsatz von Werkzeugen erleichtert wird. Für einen Zugriff auf den Hebel kann der Service das Gerät öffnen. Gemäß einer weiteren Ausführungsart weist der Hebel den zweiten Hebelarm am hinteren Ende auf. Hierdurch kann das Betätigen des Hebels bei geöffnetem Gerät erleichtert wird.

Gemäß einer weiteren Ausführungsart weist der Modulträger und/oder der Rastrahmen an mehreren hintereinander in senkrechter Richtung zum plattenförmigen Grundkörper angeordneten Rastpositionen Schnappaufnahmen (Rastaufnahmen) auf. Hierdurch wird eine Verrastung von Modulträger und Rastrahmen miteinander in verschiedenen Rastpositionen ermöglicht, in denen zwischen der Rückseite der Stützplatte und der Vorderseite des Rastrahmens unterschiedliche Abstände vorliegen. Hierdurch wird die Verwendung der Vorrichtung mit verschiedenen Geräten ermöglicht, bei denen die Wand mit der Montageöffnung unterschiedliche Wandstärken aufweist. Zudem können hierdurch grobe Toleranzen der Wandstärke eines Gerätes durch unterschiedliche Raststufen abgedeckt werden.

Gemäß einer weiteren Ausführungsart weist der Modulträger am Außenumfang mehrere erste Schnappelemente auf und weist der Rastrahmen am Innenumfang mehrere zweite Schnappelemente auf. Hierdurch können die beim Verschnappen in den einzelnen Schnappverbindungen wirksamen Kräfte gering gehalten werden und ein gleichmäßiges Festklemmen der Vorrichtung an der Wand des Gerätes erreicht werden. Gemäß einer anderen Ausführungsart weist der Modulträger nur ein einziges erstes Schnappelement und der Rastrahmen nur ein einziges zweites Schnappelement auf, wobei das erste Schnappelement komplett um den Außenumfang des Modulträgers und das zweite Schnappelement komplett um den Innenumfang des Rastrahmens herumläuft.

Gemäß einer weiteren Ausführungsart weist der Modulträger am Außenumfang mehrere symmetrisch angeordnete erste Schnappelemente auf und weist der Rastrahmen am Innenumfang mehrere symmetrisch angeordnete zweite Schnappelemente auf. Hierdurch wird ein gleichmäßiges Festklemmen der Vorrichtung am Gerät begünstigt.

Gemäß einer weiteren Ausführungsart steht das Federelement von der Vorderseite des Rastrahmens vor. Durch Zusammenfassen von Federelement und Rastrahmen zu einem einzigen Bauteil kann die Montage und Demontage erleichtert werden. Durch Anordnung des Federelementes auf der hinteren Seite der Wand kann ein durch Toleranzausgleich bedingter Spalt zwischen Vorrichtung und Wand verborgen werden.

Gemäß einer weiteren Ausführungsart weist der Rastrahmen auf der Vorderseite mindestens ein als Biegefeder ausgeführtes Federelement auf, das spitzwinklig zur Rahmenebene geneigt ist. Die Ausführung des Federelementes als geneigte Biegefeder ist bei der Herstellung durch Spritzgießen aus Kunststoff fertigungstechnisch besonders vorteilhaft.

Gemäß einer weiteren Ausführungsart weist der Rastrahmen mehrere symmetrisch angeordnete Federelemente auf. Dies ist für die gleichmäßige Anlage und für den Ausgleich unterschiedlicher Fertigungstoleranzen am Umfang der Montageöffnung von Vorteil. Die Erfindung umfasst auch Ausführungsarten, bei denen der Rastrahmen nur ein einziges Federelement aufweist, das beispielsweise durch eine umlaufende, nach vorn vorstehende, ggf. nach außen geneigte elastische Lippe an der Vorderseite des Rastrahmens gebildet sein kann.

Gemäß einer weiteren Ausführungsart weist die Stützplatte das Federelement auf. Das Federelement ist beispielsweise durch eine umlaufende, ggf. nach außen geneigte, nach hinten vorstehende elastische Lippe am Außenumfang der Stützplatte gebildet oder durch eine insgesamt als Tellerfeder aus elastischem Material ausgebildete Stützplatte.

Gemäß einer weiteren Ausführungsart ist das Federelement durch einen Ring aus einem Elastomer gebildet, der zwischen dem Rastrahmen und der hinteren Seite der Wand oder zwischen der Stützplatte und der vorderen Seite der Wand positioniert ist. Der Ring kann beispielsweise auf dem Umfang des Grundkörpers geführt und auf der hinteren Seite der Wand oder auf der vorderen Seite der Wand positioniert sein. Der Ring kann als rechteckiger Ring oder als kreisrunder Ring ausgebildet sein. Grundsätzlich kann hierfür ein O-Ring verwendet werden.

Gemäß einer weiteren Ausführungsart ist der Schnapphaken einstückig mit dem Modulträger oder mit dem Rastrahmen ausgebildet und/oder ist die Schnappaufnahme einstückig mit dem Rastrahmen oder dem Modulträger ausgebildet und/oder ist das Federelement einstückig mit dem Rastrahmen oder der Stützplatte ausgebildet. Durch die einstückige Ausbildung der genannten Strukturen mit den genannten Bauteilen werden Herstellung und Montage erleichtert. Die Herstellung kann insbesondere durch Spritzgießen aus Kunststoff erfolgen. Vorzugsweise ist sowohl der Modulträger als auch der Rastrahmen einstückig aus Kunststoff spritzgegossen.

Gemäß einer weiteren Ausführungsart ist der Modulträger aus einem Kunststoff oder einem Metall und/oder ist der Rastrahmen aus einem Kunststoff hergestellt. Gemäß einer weiteren Ausführungsart ist der Modulträger aus Aludruckguss oder gefrästem Metall hergestellt. Gemäß einer weiteren Ausführungsart ist der Modulträger aus einem Kunststoff spritzgegossen und/oder ist der Rastrahmen aus einem Kunststoff (könnt aber auch ein 2-Komponenten Spritzgussteil sein aus hart und weich Komponenten um eine Dichtfunktion zu realsieren) spritzgegossen. Gemäß einer weiteren Ausführungsart ist der Modulträger einstückig ausgebildet und/oder ist der Rastrahmen einstückig ausgebildet. Gemäß einer weiteren Ausführungsart ist die Wand und/oder ein die Wand aufweisendes Gehäuse des Gerätes aus Metall oder Kunststoff hergestellt. Als Kunststoff wird beispielsweise TSG verwendet. Gemäß einer zweiten Ausführungsart ist das Gehäuse aus Kunststoff spritzgegossen.

In der vorliegenden Anmeldung beziehen sich die Angaben "vorn" und "hinten" sowie diese Richtungsangaben umfassende Begriffe wie "Vorderseite" und "Rückseite" auf eine Anordnung der Vorrichtung an einer äußeren Wand eines Gerätes, bei der das Modul auf der Außenseite des Gerätes angeordnet ist, wobei seine Außenseite für einen von außen auf das Gerät blickenden Betrachter sichtbar ist und der Rastrahmen auf der Innenseite der äußeren Wand des Gerätes angeordnet ist.

Die erfindungsgemäße Vorrichtung wird nachfolgend anhand der anliegenden Zeichnungen von Ausführungsbeispielen näher erläutert. In den Zeichnungen zeigen:
- Fig. 1: einen Modulträger eines ersten Ausführungsbeispiels der Erfindung in einer Perspektivansicht schräg von hinten;
- Fig. 2: einen Rastrahmen derselben Vorrichtung in einer Perspektivansicht schräg von vorn;
- Fig. 3: dieselbe Vorrichtung zu Beginn der Montage an einer Montageöffnung eines Gerätes in einer Perspektivansicht schräg von hinten;
- Fig. 4: dieselbe Vorrichtung nach dem Einsetzen des Modulträgers in die Montageöffnung und vor dem Verschnappen des Modulträgers mit dem Rastrahmen in einer Perspektivansicht schräg von hinten;
- Fig. 5: dieselbe Vorrichtung mit verschnapptem Modulträger und Rastrahmen festgeklemmt am Gerät in einer Perspektivansicht schräg von hinten;
- Fig. 6: ein weiteres Ausführungsbeispiel der Erfindung in einer ersten Raststufe in einem Querschnitt senkrecht zur Wand;
- Fig. 7: dieselbe Vorrichtung in einer zweiten Raststufe in einem Querschnitt senkrecht zur Wand;
- Fig. 8: dieselbe Vorrichtung in einer dritten Raststufe in einem Querschnitt senkrecht zur Wand;
- Fig. 9: einen Modulträger eines dritten Ausführungsbeispiels der Erfindung in einer Perspektivansicht schräg von hinten;
- Fig. 10: einen Rastrahmen derselben Vorrichtung in einer Perspektivansicht schräg von vorn;
- Fig. 11: dieselbe Vorrichtung zu Beginn der Montage an einer Montageöffnung eines Gerätes in einer Perspektivansicht schräg von hinten;
- Fig. 12: dieselbe Vorrichtung nach dem Einsetzen des Modulträgers in die Montageöffnung und vor dem Verschnappen des Rastrahmen mit dem Modulträger in einer Perspektivansicht schräg von hinten;
- Fig. 13: dieselbe Vorrichtung mit verschnapptem Modulträger und Rastrahmen festgeklemmt an der Wand des Gehäuses in einer Perspektivansicht schräg von hinten.

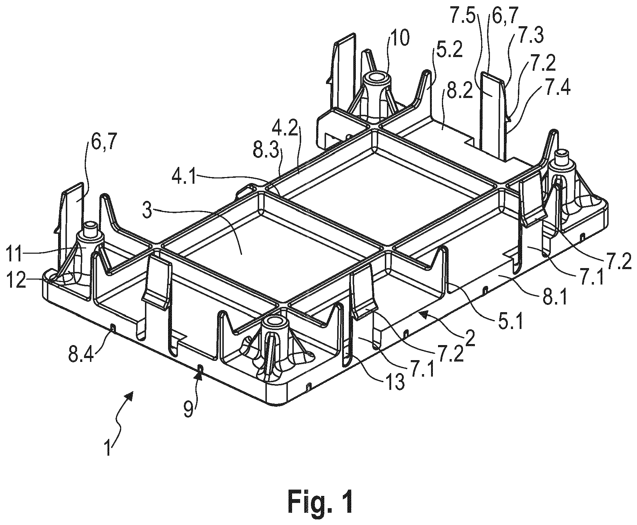

Gemäß Fig. 1 weist ein Modulträger 1 einen rechteckigen, plattenförmigen Grundkörper 2 auf. Der Grundkörper 2 weist eine Platte 3 und von der Rückseite der Platte 3 vorstehende, ineinander kreuzende Rippen 4.1, 4.2 auf. Die Rippen 4.1, 4.2 weisen teilweise an den äußeren Enden nach hinten hakenförmig vorstehende Vorsprünge 5.1, 5.2 mit senkrecht zur Platte 3 ausgerichteten Außenkanten auf.

Der Grundkörper 2 weist am Außenumfang erste Schnappelemente 6 auf, die als senkrecht von der Grundplatte nach hinten vorstehende Schnapphaken 7 ausgebildet sind.

Die Schnapphaken 7 weisen jeweils einen streifenförmigen Abschnitt 7.1 auf. In einem Abstand vom Grundkörper 2 steht vom streifenförmigen Abschnitt 7.1 nach außen ein Haken 7.2 in Form einer spitzwinklig zum streifenförmigen Abschnitt 7.1 geneigten Leiste vor. Der Haken 7.2 ist in einem Abstand vom hinteren Ende des streifenförmigen Abschnittes 7.1 angeordnet. Am hinteren Ende hat der streifenförmige Abschnitt 7.1 auf der Außenseite eine Anschrägung 7.3. Der Schnapphaken 7 bildet einen einarmigen Hebel mit einem kürzeren ersten Hebelarm 7.4 und einem längeren zweiten Hebelarm 7.5, der durch Drücken gegen die Außenseite des zweiten Hebelarms 7.5 geschwenkt werden kann.

An den beiden langen Seiten des Grundkörpers 2 sind jeweils zwei Schnapphaken 7 und an den beiden kurzen Seiten des Grundkörpers 2 ist jeweils ein Schnapphaken 7 angeordnet.

Von den seitlichen Rändern der Platte 3 des Grundkörpers 2 stehen senkrecht nach vorn leistenförmige Seitenwände 8.1-8.4 des Grundkörpers 2 vor, die eine Aussparung in Form einer Vertiefung 9 auf der Vorderseite des Grundkörpers 2 umgrenzen. Die Vertiefung 9 dient zum Einsetzen eines Moduls.

An den vier Ecken der Platte 3 stehen nach hinten zwei diagonal angeordnete Schraubdome 10 und zwei ebenfalls diagonal angeordnete Positionsnasen 11 vor, die jeweils über eine seitliche Verrippung 12 an der Rückseite der Platte 3 abgestützt sind.

An den Innenseiten der Schnapphaken weist der plattenförmige Grundkörper 3 aus fertigungstechnischen Gründen und zur Verbesserung der Elastizität der Schnapphaken rechteckige erste Durchbrüche 13 auf.

Dem Modulträger 1 ist einstückig durch Spritzgießen hergestellt.

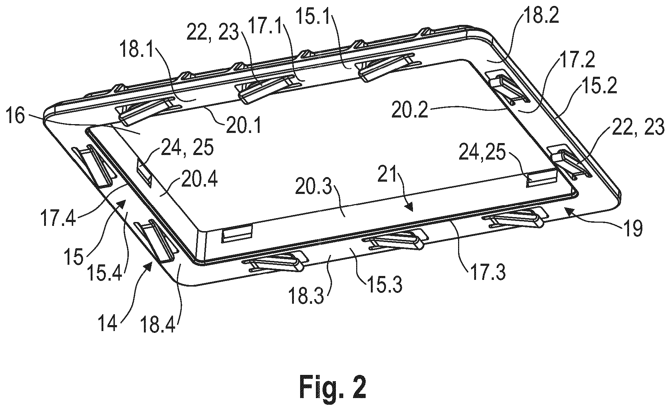

Gemäß Fig. 2 weist ein Rastrahmen 14 einen rechteckigen Rahmenkörper 15 mit vier Rahmenseiten 15.1-15.4 auf, die eine Rahmenöffnung 16 umgrenzen. Die Rahmenseiten 15.1-15.4 sind jeweils L-Profile 17.1-17.4. Erste Schenkel 18.1-18.4 der L-Profile 17.1-17.4 fallen in die Hauptebene (Ebene der größten Ausdehnung) des Rastrahmens 14 und bilden gemeinsam einen Anlageabschnitt 19 des Rastrahmens 14. Zweite Schenkel 20.1-20.4 des L-Profils 17.1-17 erstrecken sich vom Rand der Rahmenöffnung 16 aus vertikal zur Hauptebene des Rastrahmens 14 nach vorn und bilden gemeinsam einen Verbindungsabschnitt 21 des Rastrahmens 14.

Die Anlageabschnitt 19 weist auf der Vorderseite Federelemente 22 in Form von spitzwinklig zur Hauptebene geneigten Biegefedern 23 auf. An den beiden langen Rahmenseiten 15.1, 15.3 des Rastrahmens 14 sind jeweils drei Biegefedern 23 und an den beiden kurzen Rahmenseiten 15.2, 15.4 des Rastrahmens 14 sind jeweils zwei Biegefedern 23 angeordnet. Die Biegefedern 23 sind im Wesentlichen gleichmäßig über die Seiten des Anlageabschnitts 19 verteilt.

Der Verbindungsabschnitt 21 weist am Innenumfang zweite Schnappelemente 24 in Form von Schnappaufnahmen auf. Die Schnappaufnahmen 25 sind am vorderen Rand des Verbindungsabschnitts 21 angeordnet. An den beiden langen Rahmenseiten 15.1, 15.3 sind jeweils zwei Schnappaufnahmen 25 und an den beiden kurzen Rahmenseiten 15.2, 15.4 ist jeweils nur eine Schnappaufnahme 25 angeordnet.

Der Rastrahmen 14 ist einteilig aus Kunststoff spritzgegossen.

Die Form und die Abmessungen des Modulträgers 1 und des Rastrahmens 14 sind so aufeinander abgestimmt, dass der Rastrahmen 14 mit seiner Rahmenöffnung 16 von hinten auf den Modulträger 1 aufschiebbar ist, sodass die Schnapphaken 7 in die Rahmenöffnung16 und den Verbindungsabschnitt 21 eingreifen und mit den Schnappaufnahmen 25 verschnappen, indem sie mit den Haken 7.2 in die Schnappaufnahmen 25 eingreifen. In dieser Position weist die Vorderseite des Anlageabschnitts 19 des Rastrahmens 14 einen Abstand von der Vorderseite des Grundkörpers 2 auf, sodass dieser Abstandsbereich den Randbereich einer Montageöffnung einer Wand eines Gerätes aufnehmen kann.

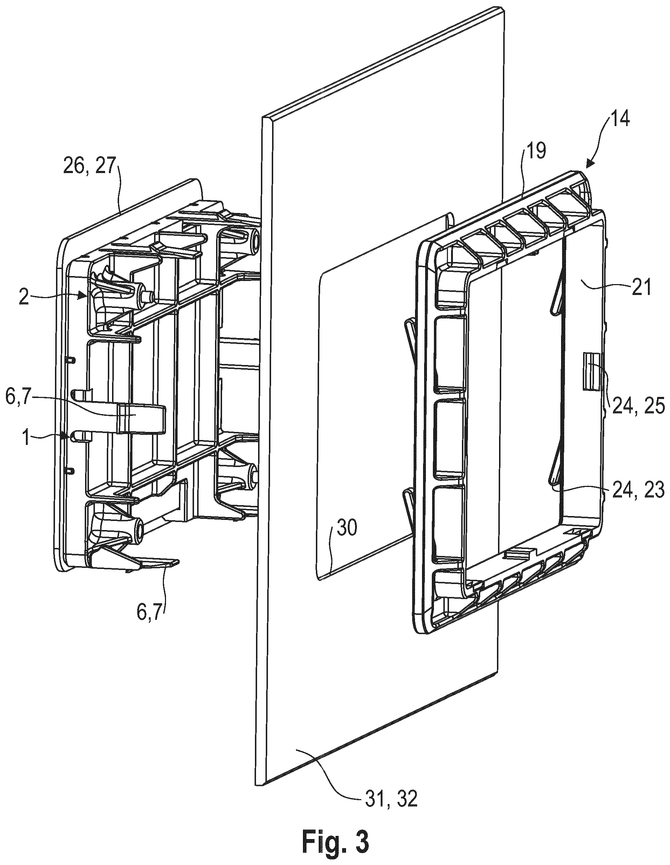

Die Vertiefung 9 des Modulträgers 1 dient dazu, ein Touchpanel oder ein anderes Modul aufzunehmen. Gemäß Fig. 3 ist ein Modul 26 in die Vertiefung 9 eingesetzt, wobei das Modul 26 eine Stützplatte 27 beispielsweise in Form eines Displayglases aufweist, die in den Seiten des Grundkörpers 2 parallel zur Hauptebene (Ebene der größten Ausdehnung) des Grundkörpers 2 nach außen vorsteht.

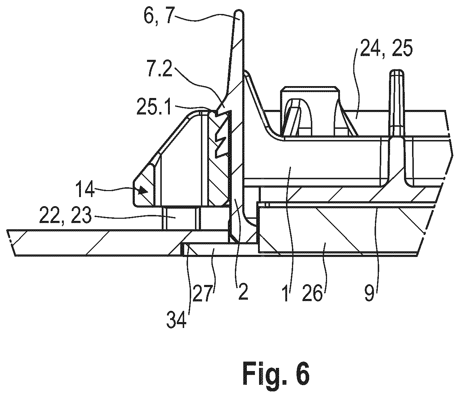

Bei dem Ausführungsbeispiel von Fig. 6, das denselben Modulträger 1 wie in Fig. 1 und einen von Fig. 2 abweichenden Rastrahmen 14 umfasst, ist das Modul 26 in der Vertiefung 9 gezeigt.

Das Modul 26 ist mittels einer Klebeverbindung an dem Modulträger 1 befestigt.

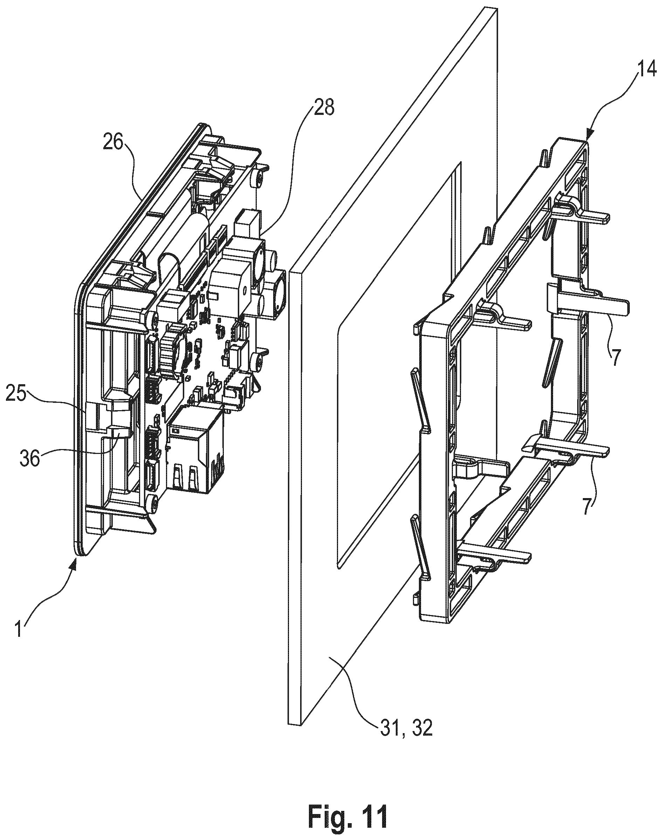

Auf der Rückseite des Modulträgers 1 ist eine rechteckige Elektronikplatine 28 mit Löchern an den Ecken montierbar, wobei in zwei diagonal auf der Elektronikplatine 28 angeordnete Positionierungslöcher die Positionsnasen 11 eingeführt werden und durch die beiden diagonal angeordneten Schraublöcher hindurch Schrauben 29 eingesetzt und in die Schraubdome 10 eingeschraubt werden. Bei dem vorliegenden Ausführungsbeispiel ist dies weggelassen und in den Fig. 11 bis 13 für ein anderes Ausführungsbeispiel gezeigt.

Gemäß Fig. 3 werden zu Beginn der Montage Modulträger 1 und Rastrahmen 14 auf eine rechteckige Montageöffnung 30 in einer Wand 31 eines Gehäuses 32 eines Gerätes ausgerichtet. Bei der Wand 31 kann es sich um eine äußere Wand eines Gehäuses 32 handeln. Grundsätzlich kann es sich bei der Wand 31 auch um eine innere Wand eines Gerätes handeln, beispielsweise um eine Wand, die zwei Funktionsbereiche des Gerätes voneinander trennt.

Die Abmessungen der Montageöffnung 30 übersteigen geringfügig die Außenabmessungen des Grundkörpers 2.

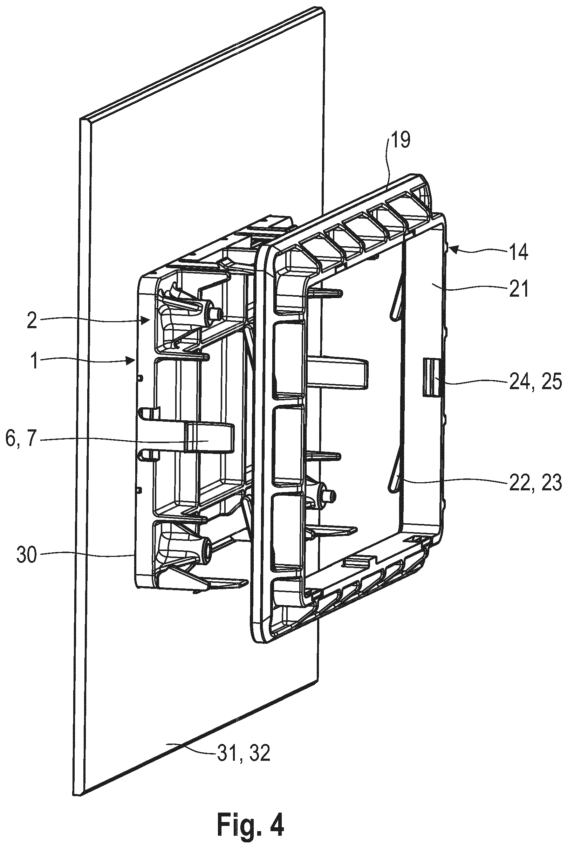

Gemäß Fig. 4 wird in einem weiteren Montageschritt der Modulträger 1 mit dem Grundkörper 2 in die Montageöffnung 30 eingesetzt, bis sich die Stützplatte 27 auf der vorderen Seite der Wand 31 abstützt.

Schließlich wird der Rastrahmen 14 von hinten auf den Modulträger 1 aufgeschoben, bis sich die Federelemente 22 an der hinteren Seite der Wand 31 abstützen, etwas einfedern und die Schnapphaken 7 in die Schnappaufnahmen 25 einschnappen.

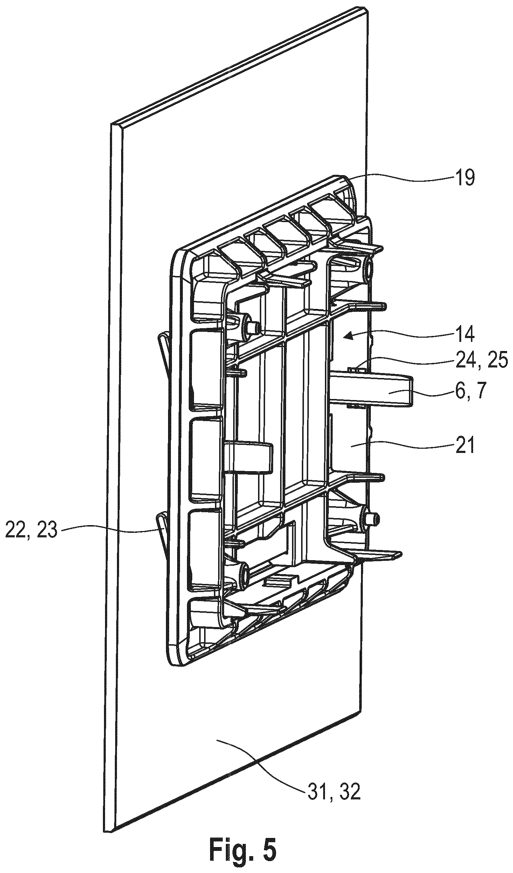

In Fig. 5 ist die Vorrichtung in der Einbaustellung gezeigt, in der der Modulträger 1 und der Rastrahmen 14 miteinander verschnappt sind und sich die Federelemente 22 elastisch verformt an der Wand 31 abstützen. In der Einbaustellung ist die aus Modulträger 1, Modul 26 und Rastrahmen 14 bestehende Vorrichtung 33 am äußeren Rand der Montageöffnung 30 an der Wand 31 festgeklemmt. Die Fertigungstoleranzen der Vorrichtung 33 und der Wand 31 werden durch die Federelemente 22 ausgeglichen. Auf eine genaue Abstimmung der Montageöffnung 30 und des Modulträgers 1 kommt es nicht an, da die Stützplatte 27 Spalte zwischen Montageöffnung 30 und Modulträger 1 außen abdeckt.

Die Montage der Vorrichtung 33 kann äußerst einfach und ohne Werkzeug durchgeführt werden. Auch ein Demontieren ist einfach und ohne Werkzeug möglich. Hierfür können die einander gegenüberliegenden Schnapphaken 7 des Modulträgers 1 an den hinteren Enden etwas zusammengedrückt werden, bis die Haken 7.2 aus den Schnappaufnahmen 25 freikommen. Danach kann der Rastrahmen 14 vom Modulträger 1 abgezogen und der Modulträger 1 aus der Montageöffnung 30 entnommen werden.

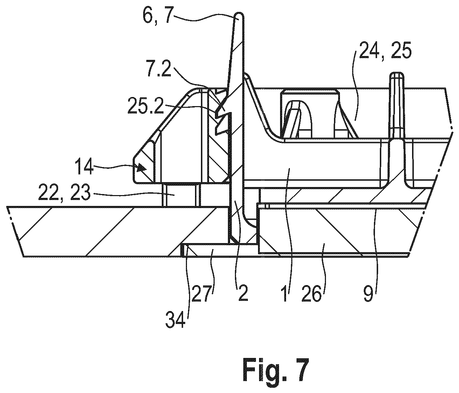

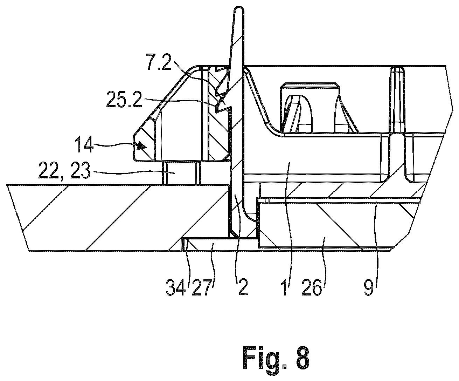

Das Ausführungsbeispiel von Fig. 6 bis 8 unterscheidet sich von dem Ausführungsbeispiel von Fig. 1 bis 5 dadurch, dass der Verbindungsabschnitt 21 des Rastrahmens 14 an mehreren hintereinander in senkrechter Richtung zum Anlageabschnitt 19 angeordneten Rastpositionen Schnappaufnahmen 25.1, 25.2, 25.3 aufweist. Infolgedessen sind der Modulträger 1 und der Rastrahmen 14 in verschiedenen Rastpositionen miteinander verschnappbar bzw. verrastbar. Dies ist vorteilhaft für einen groben Ausgleich von Fertigungstoleranzen und für die Verwendung der Vorrichtung 33 mit verschiedenen Geräten, bei denen die Montageöffnung 30 in Wänden 31 mit unterschiedlicher Wandstärke ausgebildet ist.

Die hinteren Ränder jeder Schnappaufnahme 25.1, 25.2, 25.3 sind entsprechend der Neigung der Hinterseite jedes Hakens 7.2 nach hinten geneigt, um das Verlagern des Rastrahmens 14 in eine nachfolgende Rastposition zu erleichtern.

Zudem weist dieses Ausführungsbeispiel auf der vorderen Seite der Wand 31 eine um die Montageöffnung 30 herum verlaufende Außenstufe 34 auf, die so bemessen ist, dass sie die Stützplatte 27 aufnimmt. Infolgedessen schließt die Vorderseite der Stützplatte 27 bündig mit der vorderen Seite der Wand 31 neben der Außenstufe 34 ab. Der Spalt zwischen äußerem Umfang der Stützplatte 27 und der äußeren Begrenzung der Außenstufe kann kleingehalten werden. In der Ansicht von außen ist das Modul 26 perfekt in die Wand integriert.

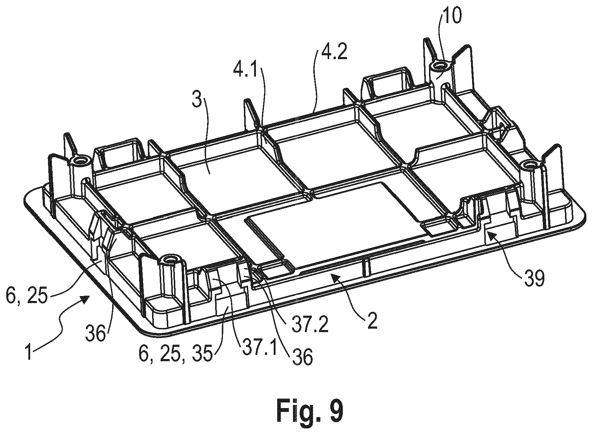

Das Ausführungsbeispiel von Fig. 9 bis 13 unterscheidet sich von dem Ausführungsbeispiel von Fig. 1 bis 5 dadurch, dass die ersten Schnappelemente 6 des Modulträgers 1 als Schnappaufnahmen 25 und nicht als Schnapphaken ausgebildet sind und dass die zweiten Schnappelemente 24 des Rastrahmens als Schnapphaken 7 und nicht als Schnappaufnahmen ausgebildet sind.

Ein weiterer Unterschied besteht darin, dass die Stützplatte 27 einstückig mit dem Modulträger 1 und nicht mit dem Modul 26 ausgebildet ist.

Der Modulträger 1 weist die Schnappaufnahmen 25 am Außenumfang der leistenförmigen Seitenwände 8.1-8.4 auf. Die Schnappaufnahmen 25 sind als rechteckige zweite Durchbrüche 35 des Modulträgers 1 ausgebildet. An den beiden langen Seiten des Grundkörpers 2 sind jeweils zwei Schnappaufnahmen 25 und an den beiden kurzen Seiten des Grundkörpers 2 ist jeweils eine Schnappaufnahme 25 angeordnet.

Auf der Rückseite weist der Grundkörper 2 neben den Schnappaufnahmen 25 nach hinten vorstehende Einführschrägen 36 auf. Die Einführschrägen 36 sind an den Außenseiten von nach hinten vorstehenden parallelen Nocken 37.1, 37.2 ausgebildet, die durch einen Verbindungssteg miteinander verbunden sind.

Die Stützplatte 27 ist ein rechteckiger Rahmen 38 mit einer Fensteröffnung 39 an der Vorderseite. Die Stützplatte 39 ist am Rand der Fensteröffnung 39 einstückig mit dem vorderen Rand der die Vertiefung 9 umgebenden leistenförmigen Seitenwände 8.1-8.4 verbunden und steht parallel zur Hauptebene des Grundkörpers 2 nach außen vor. Die Fensteröffnung 39 und die Vertiefung 9 bilden gemeinsam eine Aussparung 40 zum Einsetzen und Verkabeln eines Moduls 26.

Der Grundkörper 2 kann Durchgangsöffnungen aufweisen, um mittels hindurchgeführter Kabel ein elektronisches Modul auf der Vorderseite des Grundkörpers mit einer Elektronikplatine auf der Rückseite des Grundkörpers oder mit einer Elektronik im Gerät zu verbinden.

Der Modulträger 1 ist einteilig aus Kunststoff spritzgegossen.

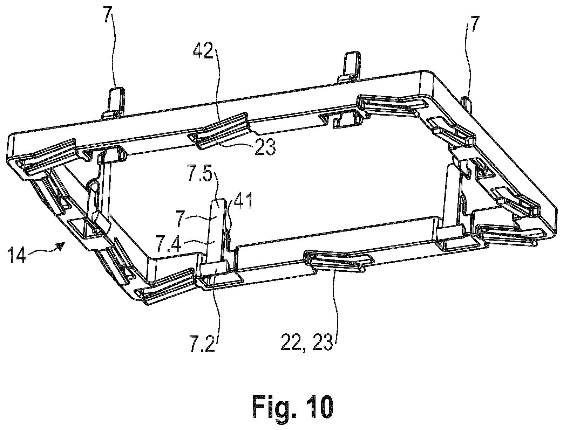

Gemäß Fig. 10 weist der Rastrahmen am Innenumfang die Schnapphaken 7 auf. Jeder Schnapphaken 7 ist über eine Verbindungslasche 41 mit dem vorderen Rand des Verbindungsabschnitttes 21 verbunden. Jeder Schnapphaken 7 weist einen streifenförmigen Abschnitt 7.1 auf, der sich senkrecht zum Anlageabschnitt 19 erstreckt und am vorderen Ende einen nach innen vorstehenden Haken 7.2 aufweist. Die Verbindungslasche 41 ist mit der Mitte des streifenförmigen Abschnittes 7.1 verbunden. Somit ist der Schnapphaken 7 als zweiarmiger Hebel ausgebildet, mit einem ersten Hebelarm 7.4 vom Haken 7.2 bis zur Verbindungslasche 41 und einen zweiten Hebelarm 7.5 von der Verbindungslasche 41 bis zum hinteren Ende des streifenförmigen Abschnitts 7.1 der durch Betätigen des zweiten Hebelarms 7.5 geschwenkt werden kann.

Die Biegefedern 23 sind auf der Vorderseite des Rastrahmens 14 oberhalb von keilförmigen Einkerbungen 42 des Anlageabschnittes 19 angeordnet, sodass die Biegefedern 23 jeweils über der tiefsten Stelle der Einkerbung 42 an den Anlageabschnitt 19 angebunden sind. Diese Anordnung ist zur Erhöhung der Dauerfestigkeit und aus fertigungstechnischen Gründen gewählt.

Der Rastrahmen 14 ist einteilig aus Kunststoff spritzgegossen.

Auf der Vorderseite des Modulträgers 1 ist in die Aussparung 40 ein Modul eingeklebt, das in den Figuren nicht sichtbar ist. Auf der Rückseite des Modulträgers 1 ist gemäß Fig. 11 bis 13 eine Elektronikplatine 28 fixiert.

Gemäß Fig. 11 werden zu Beginn der Montage der Modulträger 1 und der Rastrahmen 14 auf verschiedenen Seiten der Montageöffnung 30 angeordnet und auf diese ausgerichtet.

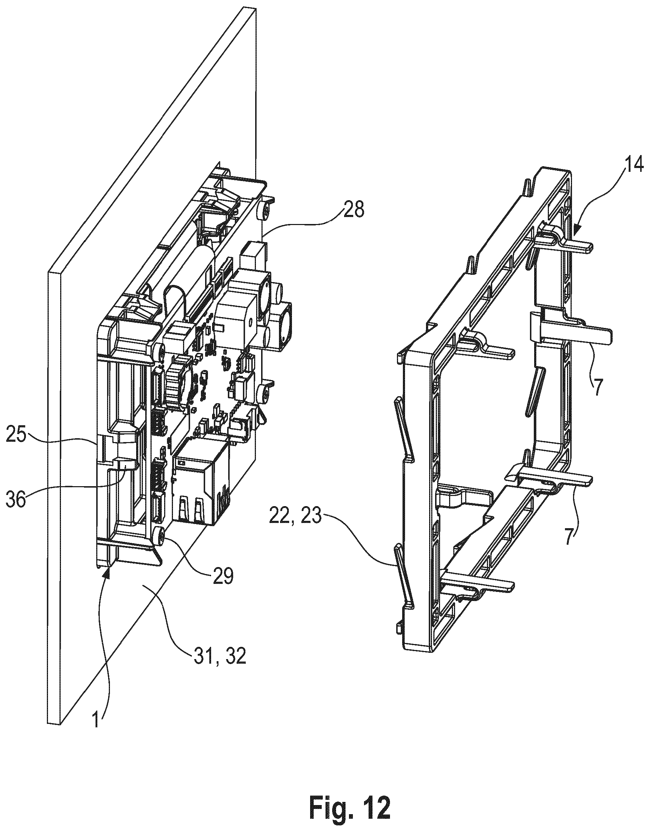

Gemäß Fig. 12 wird als nächstes der Modulträger 1 in die Montageöffnung 30 eingeschoben, bis die Stützplatte 27 an der vorderen Seite der Wand 31 anliegt.

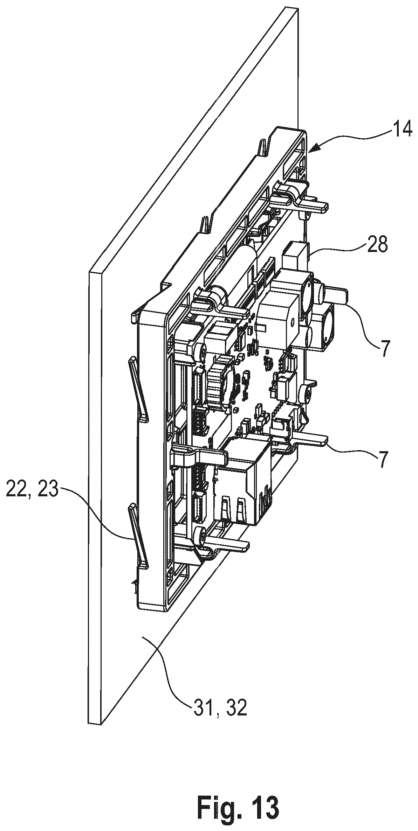

Schließlich wird gemäß Fig. 13 der Rastrahmen 14 von hinten auf den Modulträger 1 aufgeschoben, bis sich die Biegefedern 23 auf der hinteren Seite der Wand 31 abstützen, etwas einfedern und die Schnapphaken 7 in die Schnappaufnahmen 25 einschnappen. In der verschnappten Einbaustellung ist die Vorrichtung in Fig. 13 gezeigt.

Auch bei dieser Ausführungsart kompensieren die Federelemente 22 Toleranzen der beteiligten Bauteile 1, 14, 31. Die Stützplatte 27 deckt den Randbereich der Montageöffnung 30 ab, sodass es nicht auf eine genaue Anpassung des Modulträgers 1 an die Montageöffnung 30 ankommt. Die Montage kann ohne Zuhilfenahme von Werkzeugen erfolgen. Auch eine Demontage ist leicht möglich, indem die hinteren Enden einander gegenüberliegender Schnapphaken 7 etwas zusammengeschwenkt werden. Sobald die Haken 7.2 aus den Schnappaufnahmen 25 freikommen, kann der Rastrahmen 14 vom Modulträger 1 abgezogen werden. Danach ist der Modulträger 1 aus der Montageöffnung 30 entnehmbar.

Ein weiterer Vorteil ist, dass die Schnapphaken 7 Bestandteile des Rastrahmens 14 sind, sodass im Versagensfall der Rastrahmen 14 ersetzt werden muss. Der Rastrahmen 14 kann bevorzugt als Gleichteil für verschiedene Geräte verwendet werden, sodass ein Ersatz dieses Bauteils vergleichsweise kostengünstig möglich ist.

### Liste der Bezugszeichen

- 1: Modulträger
- 2: Grundkörper
- 3: Platte
- 4.1, 4.2: Rippe
- 5.1, 5.2: Vorsprung
- 6: erstes Schnappelement
- 7: Schnapphaken
- 7.1: streifenförmiger Abschnitt
- 7.2: Haken
- 7.3: Anschrägung
- 7.4: erster Hebelarm
- 7.5: zweiter Hebelarm
- 8.1-8.4: Seitenwand
- 9: Vertiefung
- 10: Schraubdom
- 11: Positionsnase
- 12: Verrippung
- 13: erster Durchbruch
- 14: Rastrahmen
- 15: Rahmenkörper
- 15.1-15.4: Rahmenseite
- 16: Rahmenöffnung
- 17.1-17.4: L-Profil
- 18.1-18.4: erster Schenkel
- 19: Anlageabschnitt
- 20.1-20.4: zweiter Schenkel
- 21: Verbindungsabschnitt
- 22: Federelement
- 23: Biegefeder
- 24: zweites Schnappelement
- 25: Schnappaufnahme
- 26: Modul
- 27: Stützplatte
- 28: Elektronikplatine
- 29: Schraube
- 30: Montageöffnung
- 31: Wand
- 32: Gehäuse
- 33: Vorrichtung
- 34: Außenstufe
- 35: zweiter Durchbruch
- 36: Einführungsschräge
- 37.1, 37.2: Nocken
- 38: Rahmen
- 39: Fensteröffnung
- 40: Aussparung
- 41: Verbindungslasche
- 42: Einkerbung

## Patentansprüche

1. Vorrichtung zur mechanischen Befestigung eines Moduls an einer Wand eines Gerätes mit einer das Modul aufnehmenden Montageöffnung, umfassend:
• einen Modulträger (1), der einen plattenförmigen Grundkörper (2) zum Einsetzen in die Montageöffnung (30) und mindestens ein erstes Schnappelement (6) am Außenumfang des Grundkörpers (2) aufweist,
• ein Modul (26), das auf der Vorderseite des Grundkörpers (2) angeordnet und am Modulträger (1) befestigt ist,
• eine Stützplatte (27) zum Abstützen auf einer vorderen Seite der Wand (31) mit der Montageöffnung (30), die mit dem Modulträger (1) oder Modul (26) verbunden ist und parallel zur Hauptebene des Grundkörpers (2) nach außen vorsteht,
• einen Rastrahmen (14), der eine Rahmenöffnung (16) zum Einsetzen eines hinteren Teils des Grundkörpers (2) und mindestens ein zweites Schnappelement (24) am Innenumfang aufweist,
• mindestens ein Federelement (22), das ausgebildet und angeordnet ist, den Rastrahmen (14) federnd auf der hinteren Seite der Wand (31) neben der Montageöffnung (30) abzustützen und/oder die Stützplatte (27) federnd auf der vorderen Seite der Wand abzustützen,
• wobei das erste Schnappelement (6) und das zweite Schnappelement (24) ausgebildet sind, miteinander zu verschnappen, wenn der Grundkörper (2) in die Rahmenöffnung (16) eingesetzt ist, wobei zwischen der Rückseite der Stützplatte (27) und der Vorderseite des Rastrahmens (14) ein Abstand zur Aufnahme eines die Montageöffnung (30) umgebenden Randbereichs der Wand (31) vorhanden ist.

2. Vorrichtung nach Anspruch 1, bei der die Stützplatte (27) einstückig mit dem Modulträger (1) oder mit dem Modul (26) verbunden ist.

3. Vorrichtung nach Anspruch 1 oder 2, bei der der Modulträger (1) auf der Vorderseite eine Aussparung (40) aufweist und das Modul (26) in die Aussparung (40) eingesetzt ist.

4. Vorrichtung nach einem der Ansprüche 1 bis 3, bei der das Modul (26) über eine Klebeverbindung mit dem Modulträger (1) verbunden ist.

5. Vorrichtung nach einem der Ansprüche 1 bis 4, bei der das Modul (26) ein Display, ein Monitor, eine Tastatur, ein Touchscreen, ein anderes UI-Modul oder eine transparente Scheibe ist.

6. Vorrichtung nach einem der Ansprüche 1 bis 5, bei der von der Rückseite des Grundkörpers (2) nach hinten Schraubdome (10) vorstehe und eine Elektronikplatine (28) mittels Schrauben (29) auf den Schaubdomen (10) befestigt ist.

7. Vorrichtung nach einem der Ansprüche 1 bis 6, bei der der Modulträger (1) am Außenumfang mindestens einen nach hinten vorstehenden Schnapphaken (7) und der Rastrahmen (14) am Innenumfang mindestens eine Schnappaufnahme (25) für den Schnapphaken (7) aufweist und/oder bei der der Rastrahmen (14) am Innenumfang mindestens einen nach vorn vorstehenden Schnapphaken (7) und der Modulträger (1) am Außenumfang mindestens eine Schnappaufnahme (25) für den Schnapphaken (7) aufweist.

8. Vorrichtung nach Anspruch 7, bei der der Schnapphaken (7) ein ein- oder zweiarmiger Hebel mit einem ersten Hebelarm (7.4) mit einem Haken (7.2) zum Einschnappen in eine Schnappaufnahme (25) und einem zweiten Hebelarm (7.3) zum Lösen der Schnappverbindung mit der Schnappaufnahme (25) ist.

9. Vorrichtung nach einem der Ansprüche 1 bis 8, bei der der Modulträger (1) und/oder der Rastrahmen (14) an mehreren hintereinander in senkrechter Richtung zum plattenförmigen Grundkörper angeordneten Rastpositionen Schnappaufnahmen (25.1, 25.2, 25.3) aufweist.

10. Vorrichtung nach einem der Ansprüche 1 bis 9, bei der der Modulträger (1) am Außenumfang mehrere erste Schnappelemente (6) aufweist und der Rastrahmen (14) am Innenumfang mehrere zweite Schnappelemente (24) aufweist.

11. Vorrichtung nach einem der Ansprüche 1 bis 10, bei der das Federelement (22) von der Vorderseite des Rastrahmens (14) vorsteht.

12. Vorrichtung nach einem der Ansprüche 1 bis 11, bei der der Rastrahmen (14) auf der Vorderseite mindestens ein als Biegefeder (23) ausgeführtes Federelement (22) aufweist, das spitzwinklig zur Rahmenebene geneigt ist.

13. Vorrichtung nach einem der Ansprüche 1 bis 12, bei der der Schnapphaken (7) einstückig mit dem Modulträger (1) oder mit dem Rastrahmen (14) ausgebildet ist und/oder bei der die Schnappaufnahme einstückig mit dem Rastrahmen (14) oder dem Modulträger (1) ausgebildet ist und/oder bei der das Federelement (22) einstückig mit dem Rastrahmen (14) oder der Stützplatte (27) ausgebildet ist.

14. Vorrichtung nach einem der Ansprüche 1 bis 13, bei der der Modulträger (1) aus einem Kunststoff und/oder der Rastrahmen (14) aus einem Kunststoff hergestellt ist.

15. Vorrichtung nach einem der Ansprüche 1 bis 14, bei der der Modulträger (1) und/oder der Rastrahmen (14) spritzgegossen ist.

## Claims

1. Device for the mechanical fastening of a module to a wall of an apparatus having a mounting opening for receiving the module comprising:
• a module carrier (1) having a plate-shaped base body (2) for insertion into the mounting opening (30) and at least a first snap element (6) on the outer circumference of the base body (2),
• a module (26) arranged on the front side of the base body (2) and fastened to the module carrier (1),
• a support plate (27) for supporting on a front side of the wall (31) having the mounting opening (30), which is connected to the module carrier (1) or module (26) and projects outward parallel to the main plane of the base body (2);
• a detent frame (14) having a frame opening (16) for inserting a rear part of the base body (2) and at least one second snap element (24) on the inner circumference, a locking frame (14), which comprises a frame opening (16) for the insertion of a rear portion of the base body (2) and has at least a second latching element (24) on the inner circumference,
• at least one spring element (22) which is designed and arranged to resiliently support the latching frame (14) on the rear side of the wall (31) adjacent to the mounting opening (30) and/or to resiliently support the support plate (27) on the front side of the wall,
• wherein the first snap element (6) and the second snap element (24) are designed to snap together when the base body (2) is inserted into the frame opening (16), wherein a gap is provided between the rear side of the support plate (27) and the front side of the detent frame (14) for receiving an edge region of the wall (31) surrounding the mounting opening (30).

2. Device according to claim 1, in which the support plate (27) is connected integrally with the module carrier (1) or with the module (26).

3. Device according to claim 1 or 2, wherein the module carrier (1) has a recess (40) on the front side and the module (26) is inserted into the recess (40).

4. Device according to any one of claims 1 to 3, wherein the module (26) is connected to the module carrier (1) by an adhesive connection.

5. Device according to any one of claims 1 to 4, wherein the module (26) is a display, a monitor, a keyboard, a touchscreen, another UI module, or a transparent pane.

6. Device according to any one of claims 1 to 5, wherein screw domes (10) project rearward from the rear side of the base body (2) and an electronic circuit board (28) is fastened to the screw domes (10) by means of screws (29).

7. Device according to any one of claims 1 to 6, wherein the module carrier (1) has at least one snap-in hook (7) projecting rearward on its outer periphery and the detent frame (14) has at least one snap-in receptacle (25) for the snap-in hook (7) on its inner periphery and/or in which the detent frame (14) has at least one snap-in hook (7) projecting forward on its inner periphery and
the module carrier (1) has at least one snap-in receptacle (25) for the snap-in hook (7) on its outer periphery.

8. Device according to claim 7, in which the snap-in hook (7) is a single-armed or two-armed lever having a first lever arm (7.4) with a hook (7.2) for snapping into the snap-in receptacle (25) and a second lever arm (7.3) for releasing the snap-in connection with the snap-in receptacle (25)

9. Device according to any one of claims 1 to 8, in which the module carrier (1) and/or the detent frame (14) has snap-in receptacles (25.1, 25.2, 25.3) at several locking positions arranged one behind the other in a direction perpendicular to the plate-shaped base body.

10. Device according to any one of claims 1 to 9, in which the module carrier (1) has several first snap elements (6) on its outer periphery, and the detent frame (14) has several second snap elements (24) on its inner periphery.

11. Device according to any one of claims 1 to 10, in which the spring element (22) projects from the front of the detent frame (14).

12. Device according to any one of claims 1 to 11, wherein the detent frame (14) has at on its front side at least one spring element (22), designed as a leaf spring (23), which is inclined at an acute angle to the plane of the frame plane.

13. Device according to any one of claims 1 to 12, wherein the snap-in hook (7) is integrally formed with the module carrier (1) or with the detent frame (14) and/or wherein the snap-fit receptable is integrally formed with the detent frame or the module carrier (1) and/or wherein the spring element (22) is integrally formed with the detent frame (14) or the support plate (27).

14. Device according to any one of claims 1 to 13, wherein the module carrier (1) is made of a plastic and/or the detent frame (14) is made of a plastic.

15. Device according to any one of claims 1 to 14, wherein the module carrier (1) and/or the detent frame (14) is injection molded.

## Revendications

1. Dispositif de fixation mécanique d'un module sur une paroi d'un appareil comportant une ouverture de montage destinée à recevoir le module, comprenant:
• un support de module (1) qui présente un corps de base (2) en forme de plaque destiné à être inséré dans l'ouverture de montage (30) et au moins un premier élément d'encliquetage (6) disposé sur le pourtour extérieur du corps de base (2),
• un module (26) qui est agencé sur la face avant du corps de base (2) et fixé au support de module (1),
• une plaque d'appui (27) destinée à s'appuyer contre une face avant de la paroi (31) pourvue de l'ouverture de montage (30), laquelle est reliée au support de module (1) ou au module (26) et s'étend vers l'extérieur parallèlement au plan principal du corps de base (2),
• un cadre de détente (14) qui présente une ouverture (16) pour l'insertion d'une partie arrière du corps de base (2) et au moins un deuxième élément d'encliquetage (24) disposé sur le pourtour intérieur,
• au moins un élément à ressort (22) conçu et agencé de manière à supporter de façon élastique le cadre de détente (14) sur la face arrière de la paroi (31) à côté de l'ouverture de montage (30) et/ou à supporter de façon élastique la plaque de support (27) sur la face avant de la paroi,
• dans lequel le premier élément d'encliquetage (6) et le deuxième élément d'encliquetage (24) étant conçus pour s'encliqueter l'un avec l'autre lorsque le corps de base (2) est inséré dans l'ouverture du cadre (16), dans lequel entre la face arrière de la plaque de support (27) et l'avant du cadre de détente (14), il y a une distance pour accueillir une zone de bord de la paroi (31) entourant l'ouverture de montage

2. Dispositif selon la revendication 1, dans lequel la plaque d'appui (27) est reliée d'un seul pièce tenant au support de module (1) ou au module (26).

3. Dispositif selon la revendication 1 ou 2, dans lequel le support de module (1) présente un évidement (40) sur sa face avant et le module (26) est inséré dans l'évidement (40).

4. Dispositif selon l'une des revendications 1 à 3, dans lequel le module (26) est relié au support de module (1) par une liaison adhésive.

5. Dispositif selon l'une des revendications 1 à 4, dans lequel le module (26) est un afficheur, un moniteur, un clavier, un écran tactile, un autre module d'interface utilisateur ou une plaque transparente.

6. Dispositif selon l'une des revendications 1 à 5, dans lequel des dômes à vis (10) font saillie vers l'arrière depuis la face arrière du corps de base (2) et une carte électronique (28) est fixée au moyen de vis (29) sur les dômes à vis (10).

7. Dispositif selon l'une des revendications 1 à 6, dans lequel le support de module (1) comporte sur son pourtour extérieur au moins un crochet à encliquetage (7) faisant saillie vers l'arrière et le cadre de détente (14) comporte sur son pourtour intérieur au moins un logement à encliquetage (25) pour le crochet à encliquetage (7) et/ou dans lequel le cadre de détente (14) comporte sur son pourtour intérieur au moins un crochet à encliquetage ( 7) faisant saillie vers l'avant le
support de module (1) présente au moins un logement à encliquetage (25) pour le crochet à encliquetage (7) sur son pourtour extérieur.

8. Dispositif selon la revendication 7, dans lequel le crochet à encliquetage (7) est un à deux bras avec un premier bras de levier (7.4) avec un crochet (7.2) pour s'encliqueter dans un logement d'encliquetage (25) et un deuxième bras de levier (7.3) pour libérer la liaison par encliquetage avec le logement d'encliquetage (25).

9. Dispositif selon l'une des revendications 1 à 8, dans lequel le support de module (1) et/ou le cadre de détente (14) présente des logements à encliquetage (25.1, 25.2, 25.3) à plusieurs positions d'encliquetage disposées les unes derrière les autres dans la direction perpendiculaire au corps de base en forme de plaque).

10. Dispositif selon l'une des revendications 1 à 9, dans lequel le support de module (1) présente, sur son pourtour extérieure, plusieurs premiers éléments d'encliquetage (6) et le cadre de détente (14) présente, sur son intérieur, plusieurs seconds éléments d'encliquetage (24).

11. Dispositif selon l'une des revendications 1 à 10, dans lequel l'élément à ressort (22) fait saillie à partir de la face avant du cadre de detente (14).

12. Dispositif selon l'une des revendications 1 à 11, dans lequel le cadre de detente (14) présente, sur sa face avant, au moins un élément ressort (22) réalisé sous forme de ressort à flexion (23), qui est incliné de façon aiguë par rapport au plan du cadre.

13. Dispositif selon l'une des revendications 1 à 12, dans lequel le crochet à encliquetage (7) est formé d'une seule pièce avec le support de module (1) ou avec le cadre de detente (14) et/ou dans lequel le logement à encliquetage est formé d'une seule pièce avec le cadre de detente (14)
ou le support de module (1) et/ou dans lequel l'élément à ressort (22) est réalisé d'un seul tenant avec le cadre de detente (14) ou la plaque d'appui (27).

14. Dispositif selon l'une des revendications 1 à 13, dans lequel le support de module (1) est fabriqué en matière plastique et/ou le cadre de detente (14) est fabriqué en matière plastique.

15. Dispositif selon l'une des revendications 1 à 14, dans lequel le support de module (1) et/ou le cadre de detente (14) est moulé par injection.
